# EUROPEAN PATENT APPLICATION

(11) **EP 4 435 144 A2**
(43) Date of publication of application: **25.09.2024**
(21) Application number: 24156714.8
(22) Date of filing: 09.02.2024
(51) Int. Cl.: C23C 16/04, C23C 16/34, C23C 16/40, C23C 16/455

(54) **METHOD OF PROCESSING SUBSTRATE, METHOD OF MANUFACTURING SEMICONDUCTOR DEVICE, SUBSTRATE PROCESSING APPARATUS, AND PROGRAM**

(30) Priority: 24.02.2023 JP 2023027702
(71) Applicant: Kokusai Electric Corporation, Tokyo 101-0045 (JP)
(72) Inventor: ISOBE, Noriyuki, Toyama, 9392393 (JP); NAGATOMI, Yoshimasa, Toyama, 9392393 (JP)
(74) Representative: Bardehle Pagenberg Partnerschaft mbB Patentanwälte Rechtsanwälte

(57) **Abstract**

There is provided a technique that includes: (a1) supplying a first modifying gas to a substrate; (a2) supplying a first process gas containing a first element to the substrate; (b1) supplying a second modifying gas to the substrate; and (b2) supplying a second process gas, which contains a second element and is more readily adsorbed on a surface of the substrate than the first process gas under a same condition, to the substrate, wherein (a1) and (a2) are performed a first number of times and (b1) and (b2) are performed a second number of times to form a film containing the first element and the second element, and wherein (b1) is performed under a condition in which the second modifying gas is more readily adsorbed on the surface of the substrate than the first modifying gas under a same condition.

## Description

### CROSS-REFERENCE TO RELATED APPLICATION

This application is based upon and claims the benefit of priority from Japanese Patent A pplication No. 2023-027702, filed on February 24, 2023, the entire contents of which are incorp orated herein by reference.

### TECHNICAL FIELD

The present disclosure relates to a method of processing a substrate, a method of manufa cturing a semiconductor device, a substrate processing apparatus, and a program.

### BACKGROUND

As a process of manufacturing a semiconductor device, a process of forming a film on a s urface including a recess may be often carried out.

### SUMMARY

Some embodiments of the present disclosure provide a technique capable of improving t he step coverage of a film formed on a substrate.

According to one embodiment of the present disclosure, there is provided a technique th at includes: (a1) supplying a first modifying gas to the substrate; (a2) supplying a first process ga s containing a first element to the substrate; (b1) supplying a second modifying gas to the substr ate; and (b2) supplying a second process gas, which contains a second element and is more readi ly adsorbed on a surface of the substrate than the first process gas under a same condition, to th e substrate, wherein (a₁) and (a2) are performed a first number of times and (b1) and (b2) are pe rformed a second number of times to form a film containing the first element and the second ele ment, and wherein (b1) is performed under a condition in which the second modifying gas is mo re readily adsorbed on the surface of the substrate than the first modifying gas under a same con dition.

### BRIEF DESCRIPTION OF DRAWINGS

The accompanying drawings, which are incorporated in and constitute a part of the speci fication, illustrate embodiments of the present disclosure.
FIG. 1 is a schematic configuration view of a vertical process furnace of a substrate proce ssing system suitably used in each embodiment of the present disclosure, in which a portion of t he process furnace is shown in a vertical cross section.
FIG. 2 is a schematic configuration view of the vertical process furnace of the substrate p rocessing system suitably used in each embodiment of the present disclosure, in which a portion of the process furnace is shown in a cross section taken along line A-A in FIG. 1.
FIG. 3 is a schematic configuration diagram of a controller of the substrate processing system suitably used in each embodiment of the present disclosure, in which a control system of the controller is shown in a block diagram.
FIG. 4 is a diagram showing one example of a substrate processing sequence according to one embodiment of the present disclosure.
FIG. 5 is a diagram showing one example of a substrate processing sequence according to one embodiment of the present disclosure.
FIG. 6A is a view showing adsorption locations of a first modifying gas in a recess of a wa fer.
FIG. 6B is a view showing adsorption locations of a first process gas supplied to the wafe r after the first modifying gas is adsorbed on the recess of the wafer.
FIG. 6C is a view showing a first film formed after a cycle including a step of supplying th e first modifying gas to the wafer and a step of supplying the first process gas to the wafer is perf ormed a predetermined number of times.
FIG. 6D is a view showing adsorption locations of a second modifying gas in the recess of the wafer after the first film is formed.
FIG. 6E is a view showing adsorption locations of a second process gas supplied to the w afer after the second modifying gas is adsorbed on the first film.
FIG. 6F is a view showing a second film formed after a cycle including a step of supplying the second modifying gas to the wafer and a step of supplying the second process gas to the wafe r is performed a predetermined number of times.
FIG. 7 is a view showing an example of a first recess and a second recess of the recess pro vided on the surface of the wafer.

### DETAILED DESCRIPTION

Reference will now be made in detail to various embodiments, examples of which are illu strated in the accompanying drawings. In the following detailed description, numerous specific details are set forth in order to provide a thorough understanding of the present disclosure. Ho wever, it will be apparent to one of ordinary skill in the art that the present disclosure may be pr acticed without these specific details. In other instances, well-known methods, procedures, syst ems, and components have not been described in detail so as not to unnecessarily obscure aspec ts of the various embodiments.

### < Embodiments of the Present Disclosure>

Embodiments of the present disclosure will now be described mainly with reference to FI GS. 1 to 4, 6A to 6F, and 7. The drawings used in the following description are all schematic, an d the dimensional relationship, ratios, and the like of various elements shown in figures do not a lways match the actual ones. Further, the dimensional relationship, ratios, and the like of vario us elements between plural figures do not always match each other.

### (1) Configuration of Substrate Processing Apparatus

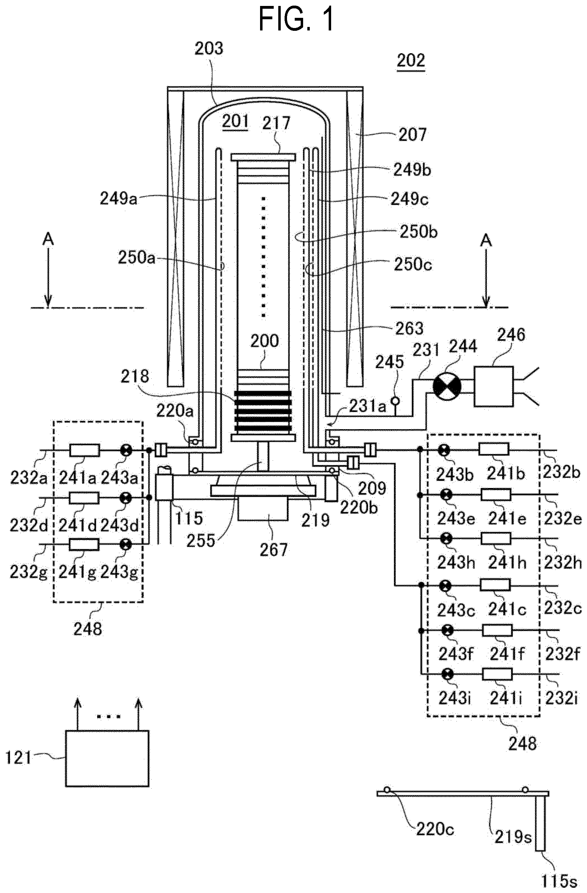

As shown in FIG. 1, a process furnace 202 includes a heater 207 as a heating mechanism (a temperature regulator). The heater 207 has a cylindrical shape and is supported by a support plate to be vertically installed. The heater 207 also functions as an activation mechanism (an ex citation part) configured to thermally activate (excite) a gas.

A reaction tube 203 is disposed inside the heater 207 to be concentric with the heater 20 7. The reaction tube 203 is made of, for example, a heat resistant material such as quartz (SiO₂) or silicon carbide (SiC), and has a cylindrical shape with its upper end closed and its lower end o pened. A manifold 209 is disposed to be concentric with the reaction tube 203 under the reactio n tube 203. The manifold 209 is made of, for example, a metal material such as stainless steel ( SUS), and has a cylindrical shape with both of its upper and lower ends opened. The upper end portion of the manifold 209 engages with the lower end portion of the reaction tube 203 to supp ort the reaction tube 203. An O-ring 220a serving as a seal member is provided between the ma nifold 209 and the reaction tube 203. Similar to the heater 207, the reaction tube 203 is vertical ly installed. A process container (reaction container) mainly includes the reaction tube 203 and the manifold 209. A process chamber 201 is formed in a hollow cylindrical portion of the proces s container. The process chamber 201 is configured to accommodate a plurality of wafers 200 a s substrates. Processing on the wafers 200 is performed in the process chamber 201.

Nozzles 249a to 249c as first to third suppliers are provided in the process chamber 201 t o penetrate through a sidewall of the manifold 209. The nozzles 249a to 249c are also referred t o as first to third nozzles, respectively. The nozzles 249a to 249c are made of, for example, a hea t resistant material such as quartz or SiC. Gas supply pipes 232a to 232c are connected to the no zzles 249a to 249c, respectively. The nozzles 249a to 249c are different nozzles, and each of the nozzles 249a and 249c is provided adjacent to the nozzle 249b.

Mass flow controllers (MFCs) 241a to 241c, which are flow rate controllers (flow rate con trol parts), and valves 243a to 243c, which are opening/closing valves, are provided in the gas su pply pipes 232a to 232c, respectively, sequentially from the upstream side of a gas flow. Each of gas supply pipes 232d and 232g is connected to the gas supply pipe 232a at the downstream side of the valves 243a. Each of gas supply pipes 232e and 232h is connected to the gas supply pipe 2 32b at the downstream side of the valves 243b. Each of gas supply pipes 232f and 232i is connec ted to the gas supply pipe 232c at the downstream side of the valves 243c. MFCs 241d to 241i an d valves 243d to 243i are provided in the gas supply pipes 232d to 232i, respectively, sequentiall y from the upstream side of a gas flow. The gas supply pipes 232a to 232i are made of, for exam ple, a metal material such as SUS.

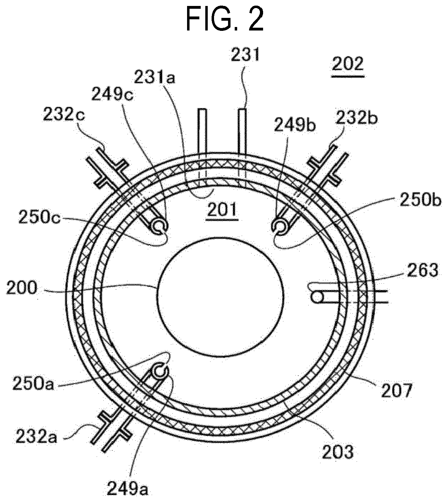

As shown in FIG. 2, each of the nozzles 249a to 249c is provided in an annular space (in plane view) between an inner wall of the reaction tube 203 and the wafers 200 to extend upward from a lower portion of the inner wall of the reaction tube 203 to an upper portion thereof, that i s, along an arrangement direction of the wafers 200. Specifically, each of the nozzles 249a to 24 9c is provided in a region horizontally surrounding a wafer arrangement region in which the waf ers 200 are arranged at a lateral side of the wafer arrangement region, along the wafer arrangem ent region.

The nozzle 249a is disposed farther from an exhaust port 231a, which will be described la ter, than the nozzles 249b and 249c. That is, the nozzles 249b and 249c are disposed closer to t he exhaust port 231a than the nozzle 249a. Further, in a plane view, the nozzles 249b and 249c are arranged in line symmetry with a straight line passing through the centers of the wafers 200 in a state in which the wafers 200 are loaded into the process chamber 201, that is, the center of the reaction tube 203 and the center of the exhaust port 231a, as the axis of symmetry. Further, the nozzles 249a and 249b are arranged to face each other on a straight line with the center of th e reaction tube 203 therebetween.

A first modifying gas is supplied from the gas supply pipe 232a into the process chamber 201 via the MFC 241a, the valve 243a, and the nozzle 249a.

A second modifying gas is supplied from the gas supply pipe 232b into the process cham ber 201 via the MFC 241b, the valve 243b, and the nozzle 249b.

A first reaction gas as a first process gas is supplied from the gas supply pipe 232c into th e process chamber 201 via the MFC 241c, the valve 243c, and the nozzle 249c.

A first precursor gas as the first process gas is supplied from the gas supply pipe 232d int o the process chamber 201 via the MFC 241d, the valve 243d, the gas supply pipe 232b, and the nozzle 249b.

A second precursor gas as a second process gas is supplied from the gas supply pipe 232e into the process chamber 201 via the MFC 241e, the valve 243e, the gas supply pipe 232b, and th e nozzle 249b.

A second reaction gas as the second process gas is supplied from the gas supply pipe 232f into the process chamber 201 via the MFC 241f, the valve 243f, the gas supply pipe 232c, and the nozzle 249c.

An inert gas is supplied from the gas supply pipes 232g to 232i into the process chamber 201 via the MFCs 241g to 241i, the valves 243g to 243i, the gas supply pipes 232a to 232c, and th e nozzles 249a to 249c, respectively. The inert gas acts as a purge gas, a carrier gas, a dilution ga s, or the like.

A first modifying gas supplier mainly includes the gas supply pipe 232a, the MFC 241a, a nd the valve 243a. A second modifying gas supplier mainly includes the gas supply pipe 232b, t he MFC 241b, and the valve 243b. A first process gas supplier (a first precursor gas supplier and a first reaction gas supplier) mainly includes the gas supply pipes 232c and 232d, the MFCs 241c and 241d, and the valves 243c and 243d. A second process gas supplier (a second precursor gas supplier and a second reaction gas supplier) mainly includes the gas supply pipes 232e and 232f, the MFCs 241e and 241f, and the valves 243e and 243f. An inert gas supplier mainly includes th e gas supply pipes 232g to 232i, the MFCs 241g to 241i, and the valves 243g to 243i.

Any or all of the above-described various gas suppliers may be configured as an integrate d-type gas supply system 248 in which the valves 243a to 243i, the MFCs 241a to 241i, and so on are integrated. The integrated-type gas supply system 248 is connected to each of the gas supply pipes 232a to 232i. In addition, the integrated-type gas supply system 248 is configured such th at operations of supplying various gases into the gas supply pipes 232a to 232i (that is, the openi ng/closing operation of the valves 243a to 243i, the flow rate adjustment operation by the MFCs 241a to 241i, and the like) are controlled by a controller 121 which will be described later. The in tegrated-type gas supply system 248 is configured as an integral type or detachable-type integrat ed unit, and may be attached to and detached from the gas supply pipes 232a to 232i and the lik e on an integrated unit basis, so that the maintenance, replacement, extension, etc. of the integr ated-type gas supply system 248 can be performed on an integrated unit basis.

The exhaust port 231a for exhausting an internal atmosphere of the process chamber 201 is installed in the lower portion of the sidewall of the reaction tube 203. The exhaust port 231a may be installed to extend from a lower portion of the sidewall of the reaction tube 203 to an up per portion thereof, that is, along the wafer arrangement region. An exhaust pipe 231 is connect ed to the exhaust port 231a. A vacuum exhaust device, for example, a vacuum pump 246, is con nected to the exhaust pipe 231 via a pressure sensor 245, which is a pressure detector (pressure detection part) for detecting the internal pressure of the process chamber 201, and an auto press ure controller (APC) valve 244, which is a pressure regulator (pressure adjustment part). The A PC valve 244 is configured to perform or stop a vacuum exhausting operation in the process cha mber 201 by opening/closing the valve while the vacuum pump 246 is actuated, and is also confi gured to adjust the internal pressure of the process chamber 201 by adjusting an opening degree of the valve based on pressure information detected by the pressure sensor 245 while the vacuu m pump 246 is actuated. An exhaust system mainly includes the exhaust pipe 231, the APC valv e 244, and the pressure sensor 245. The exhaust system may include the vacuum pump 246.

A seal cap 219, which serves as a furnace opening cover configured to hermetically seal a lower end opening of the manifold 209, is provided under the manifold 209. The seal cap 219 is made of, for example, a metal material such as SUS, and is formed in a disc shape. An O-ring 22 0b, which is a seal member making contact with the lower end of the manifold 209, is provided on an upper surface of the seal cap 219. A rotator 267 configured to rotate a boat 217, which will be described later, is installed under the seal cap 219. A rotary shaft 255 of the rotator 267 is co nnected to the boat 217 through the seal cap 219. The rotator 267 is configured to rotate the waf ers 200 by rotating the boat 217. The seal cap 219 is configured to be vertically moved up and do wn by a boat elevator 115 which is an elevating mechanism installed outside the reaction tube 20 3. The boat elevator 115 is configured as a transfer device (transfer mechanism) which loads/unl oads (transfers) the wafers 200 into/out of the process chamber 201 by moving the seal cap 219 up and down.

A shutter 219s, which serves as a furnace opening cover configured to hermetically seal a lower end opening of the manifold 209 in a state where the seal cap 219 is lowered and the boat 217 is unloaded from the process chamber 201, is provided under the manifold 209. The shutter 219s is made of, for example, a metal material such as SUS, and is formed in a disc shape. An O-ring 220c, which is a seal member making contact with the lower end of the manifold 209, is pro vided on an upper surface of the shutter 219s. The opening/closing operation (such as elevation operation, rotation operation, or the like) of the shutter 219s is controlled by a shutter opener/cl oser 115s.

The boat 217 serving as a substrate support is configured to support a plurality of wafers 200, for example, 25 to 200 wafers, in such a state that the wafers 200 are arranged in a horizon tal posture and in multiple stages along a vertical direction with the centers of the wafers 200 ali gned with one another. That is, the boat 217 is configured to arrange the wafers 200 to be space d apart from each other. The boat 217 is made of, for example, a heat resistant material such as quartz or SiC. Heat insulating plates 218 made of, for example, a heat resistant material such as quartz or SiC are installed below the boat 217 in multiple stages. In the present disclosure, the n otation of a numerical range such as "25 to 200 wafers" means that the lower limit value and the upper limit value are included in the range. Therefore, for example, "25 to 200 wafers" means " 25 wafers or more and 200 wafers or less." The same applies to other numerical ranges.

A temperature sensor 263 serving as a temperature detector is installed in the reaction tu be 203. Based on temperature information detected by the temperature sensor 263, a state of su pplying electric power to the heater 207 is adjusted such that an interior of the process chamber 201 has a desired temperature distribution. The temperature sensor 263 is provided along the i nner wall of the reaction tube 203.

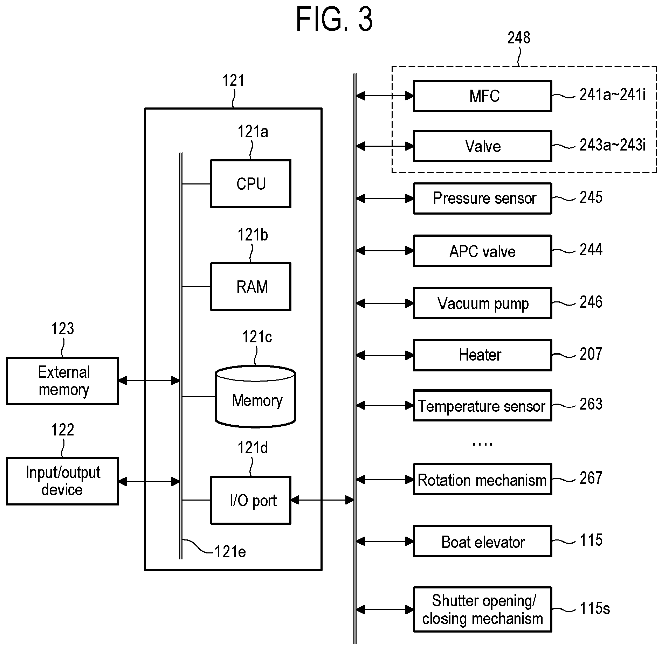

As shown in FIG. 3, a controller 121, which is a control part (control means), is configure d as a computer including a central processing unit (CPU) 121a, a random access memory (RAM ) 121b, a memory 121c, and an I/O port 121d. The RAM 121b, the memory 121c, and the I/O port 121d are configured to be capable of exchanging data with the CPU 121a via an internal bus 121e. An input/output device 122 formed of, e.g., a touch panel or the like, is connected to the controll er 121. Further, an external memory 123 may be connected to the controller 121.

The memory 121c is configured by, for example, a flash memory, a hard disk drive (HDD) , a solid state drive (SSD), or the like. A control program for controlling operations of a substrat e processing apparatus, a process recipe in which sequences and conditions of substrate processi ng to be described later are written, etc. are readably stored in the memory 121c. The process re cipe functions as a program for causing the controller 121 to execute each sequence in the substr ate processing, which will be described later, to obtain an expected result. Hereinafter, the proc ess recipe and the control program may be generally and simply referred to as a "program." Fur thermore, the process recipe may be simply referred to as a "recipe." When the term "program" is used herein, it may indicate a case of including the recipe only, a case of including the control program only, or a case of including both the recipe and the control program. The RAM 121b is configured as a memory area (work area) in which programs or data read by the CPU 121a are te mporarily stored.

The I/O port 121d is connected to the MFCs 241a to 241i, the valves 243a to 243i, the pre ssure sensor 245, the APC valve 244, the vacuum pump 246, the temperature sensor 263, the he ater 207, the rotator 267, the boat elevator 115, the shutter opener/closer 115s, and so on.

The CPU 121a is configured to read and execute the control program from the memory 12 1c. The CPU 121a is also configured to read the recipe from the memory 121c according to an inp ut of an operation command from the input/output device 122. The CPU 121a is configured to c ontrol the flow rate adjusting operation of various kinds of gases by the MFCs 241a to 241i, the o pening/closing operation of the valves 243a to 243g, the opening/closing operation of the APC v alve 244, the pressure adjusting operation performed by the APC valve 244 based on the pressur e sensor 245, the actuating and stopping operation of the vacuum pump 246, the temperature a djusting operation performed by the heater 207 based on the temperature sensor 263, the opera tion of rotating the boat 217 with the rotator 267 and adjusting the rotation speed of the boat 217 , the operation of moving the boat 217 up and down by the boat elevator 115, the opening/closing operation of the shutter 219s by the shutter opener/closer 115s, and so on, according to contents of the read recipe.

The controller 121 may be configured by installing, on the computer, the aforementioned program recorded and stored in the external memory 123. Examples of the external memory 12 3 may include a magnetic disk such as a HDD, an optical disc such as a CD, a magneto-optical di sc such as a MO, a semiconductor memory such as a USB memory or a SSD, and the like. The m emory 121c or the external memory 123 is configured as a non-transitory computer-readable rec ording medium. Hereinafter, the memory 121c and the external memory 123 may be generally a nd simply referred to as a "recording medium". When the term "recording medium" is used her ein, it may indicate a case of including the memory 121c only, a case of including the external me mory 123 only, or a case of including both the memory 121c and the external memory 123. Furth ermore, the program may be provided to the computer using communication means such as the Internet or a dedicated line, instead of using the external memory 123.

### (2) Substrate Processing Process

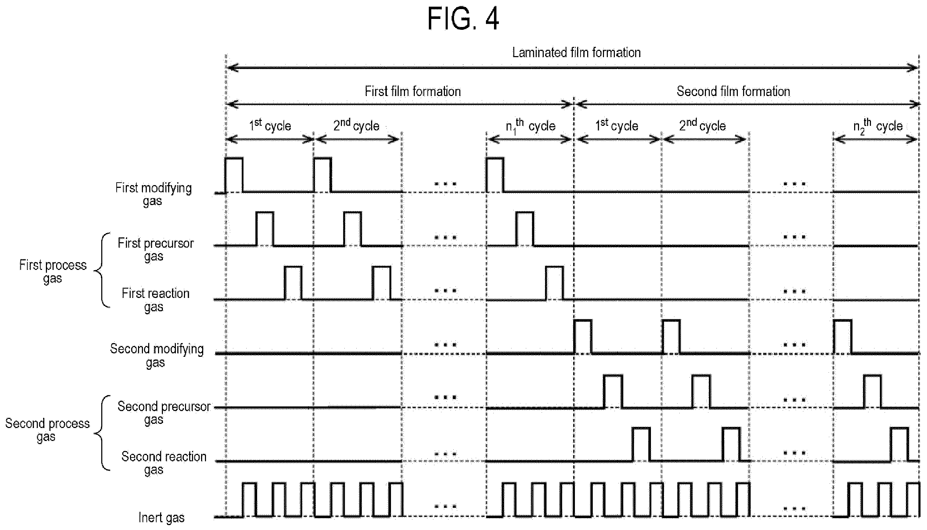

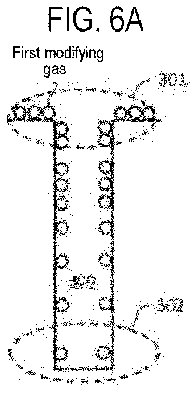

As a process of manufacturing a semiconductor device using the above-described substra te processing apparatus, an example of a processing sequence for forming a film on a wafer 200 as a substrate including a recess such as a trench formed on its surface will be described mainly with reference to FIGS. 4 and 6A to 6F. In the following description, the operations of the respe ctive parts constituting the substrate processing apparatus are controlled by the controller 121.

A processing sequence in the present embodiment includes:
(a1) a step of supplying the first modifying gas to a wafer 200;
(a2) a step of supplying a first process gas containing a first element to the wafer 200;
(b1) a step of supplying a second modifying gas to the wafer 200; and
(b2) a step of supplying a second process gas, which contains a second element and is m ore readily adsorbed on a surface of the wafer 200 than the first process gas under a same condit ion, to the wafer 200,
wherein (a1) and (a2) are performed a first number of times (n₁ times, where n₁ is an int eger of 1 or 2 or more) and (b1) and (b2) are performed a second number of times (n₂ times, whe re n₂ is an integer of 1 or 2 or more) to form a film containing the first element and the second el ement (film-forming step), and
wherein (b1) is performed under a condition where the second modifying gas is more re adily adsorbed on the surface of the wafer 200 than the first modifying gas under a same conditi on.

In the following example, a case will be described in which the first process gas is a gas (f ilm-forming gas) including a first precursor gas and a first reaction gas and the second process g as is a gas (film-forming gas) including a second precursor gas and a second reaction gas. Here, the second precursor gas is a gas that is more readily adsorbed on the surface of the wafer 200 t han the first precursor gas under the same conditions. Further, in the following example, a case will be described in which the first precursor gas containing the first element and the first reacti on gas are supplied as the first process gas containing the first element and the second precursor gas containing the second element and the second reaction gas are supplied as the second proce ss gas containing the second element.

Further, in the following example, a case will be described in which the first modifying ga s is a gas (film-formation-inhibiting gas) that inhibits the reaction between the first process gas ( first precursor gas and/or first reaction gas) and the surface of the wafer 200, and the second m odifying gas is a gas (film formation inhibiting gas) that inhibits the reaction between the second process gas (second precursor gas and/or second reaction gas) and the surface of the wafer 200.

Further, in the following, as a typical example, as shown in FIG. 4, a case will be describe d in which in the film-forming step, a laminated film formed by laminating a first film containin g the first element and a second film containing the second element is formed by performing a c ycle a first number of times (n₁ times, where n₁ is an integer of 1 or 2 or more), the cycle includin g performing step A1 of supplying the first modifying gas to the wafer 200, step A2 of supplying the first precursor gas as the first process gas to the wafer 200, and step A3 of supplying the first reaction gas as the first process gas to the wafer 200, to form the first film containing the first el ement, and performing a cycle a second number of times (n₂ times, where n₂ is an integer of 1 or 2 or more), the cycle including performing step B1 of supplying the second modifying gas to the wafer 200 on which the first film is formed, step B2 of supplying the second precursor gas as the second process gas to the wafer 200 on which the first film is formed, and step B3 of supplying t he second reaction gas as the second process gas to the wafer 200 on which the first film is form ed, to form the second film containing the second element on the first film.

In this embodiment, a case will be described in which the first film formation and the sec ond film formation are performed once respectively to form a laminated film. Here, the laminat ed film may be a film containing the first element and the second element. Further, the laminat ed film formation may be the formation of a film containing the first element and the second ele ment.

In the present disclosure, for the sake of convenience, the processing sequence shown in FIG. 4 may be denoted as follows. The same denotation may be used in modifications and other embodiments to be described later.

(First modifying gas → First precursor gas → First reaction gas) × n₁ → (Second modifyi ng gas → Second precursor gas → Second reaction gas) × n₂

When the term "wafer" is used in the present disclosure, it may refer to "a wafer itself" or "a wafer and a stacked body of certain layers or films formed on a surface of the wafer." When t he phrase "a surface of a wafer" is used in the present disclosure, it may refer to "a surface of a w afer itself' or "a surface of a certain layer formed on a wafer." When the expression "a certain la yer is formed on a wafer" is used in the present disclosure, it may mean that "a certain layer is fo rmed directly on a surface of a wafer itself' or that "a certain layer is formed on a layer formed o n a wafer." When the term "substrate" is used in the present disclosure, it may be synonymous with the term "wafer".

The term "layer" used in the present disclosure includes at least one of a continuous laye r or a discontinuous layer. A layer formed in each step to be described later may include a conti nuous layer, a discontinuous layer, or both of them.

### (Wafer Charging and Boat Loading)

After the boat 217 is charged with a plurality of wafers 200 (wafer charging), the shutter 219s is moved by the shutter opener/closer 115s and the lower end opening of the manifold 209 i s opened (shutter open). Thereafter, as shown in FIG. 1, the boat 217 charged with the plurality of wafers 200 is lifted up by the boat elevator 115 to be loaded into the process chamber 201 (boa t loading). In this state, the seal cap 219 seals the lower end of the manifold 209 through the O-r ing 220b. Thus, the wafers200 are prepared inside the process chamber 201.

### (Pressure Adjustment and Temperature Adjustment)

After the boat loading is completed, the interior of the process chamber 201, that is, a sp ace where the wafers 200 are placed, is vacuum-exhausted (decompression-exhausted) by the va cuum pump 246 to reach a desired pressure (degree of vacuum). At this time, the internal press ure of the process chamber 201 is measured by the pressure sensor 245, and the APC valve 244 i s feedback-controlled based on the measured pressure information. Further, the wafers 200 in t he process chamber 201 are heated by the heater 207 to have a desired processing temperature. At this time, the state of supplying electric power to the heater 207 is feedback-controlled based on the temperature information detected by the temperature sensor 263 so that the interior of t he process chamber 201 has a desired temperature distribution. Further, the rotation of the waf ers 200 by the rotator 267 is started. The exhaust of the interior of the process chamber 201 and the heating and rotation of the wafers 200 are continuously performed at least until the processi ng on the wafers 200 is completed.

### <Laminated Film Formation>

### (First Film Formation)

In the first film formation, the following steps A1, A2, and A3 are performed.

### [Step A1]

In step A1, a first modifying gas is supplied to the wafer 200 in the process chamber 201.

Specifically, the valve 243a is opened to allow the first modifying gas to flow into the gas supply pipe 232a. The flow rate of the first modifying gas is adjusted by the MFC 241a, and the f irst modifying gas is supplied into the process chamber 201 via the nozzle 249a and is exhausted through the exhaust port 231a. In this operation, the first modifying gas is supplied to the wafer 200 (first modifying gas supply). At this time, the valves 243g to 243i may be opened to allow a n inert gas to be supplied into the process chamber 201 via the nozzles 249a to 249c, respectivel y.

By supplying the first modifying gas to the wafer 200 under the process conditions to be described later, the first modifying gas is adsorbed on the surface of the wafer 200, thereby mod ifying at least a portion of the surface of the wafer 200. Further, by supplying the first modifyin g gas to the wafer 200 under the process conditions to be described later, the first modifying gas can be less likely to be adsorbed on the surface of the wafer 200 than a second modifying gas un der the same conditions. Further, by supplying the first modifying gas to the wafer 200 under th e process conditions to be described later, the amount of the first modifying gas adsorbed on the deep side 302 of a recess 300 can be made smaller than the amount of the first modifying gas ad sorbed on the opening side 301 thereof (see FIG. 6A). The first modifying gas prevents the adsor ption of a first precursor gas and/or a first reaction gas on the surface of the wafer 200 to inhibit (suppress) the progress of film formation reaction on the surface of the wafer 200 in steps A2 an d A3 which will be described later. In the present disclosure, the "deep side 302 of the recess 30 o" refers to a location and its surrounding region, such as the bottom of the recess 300, that are difficult for a gas supplied to the wafer 200 to reach, as compared to the opening side 301 of the recess 300.

The process conditions for supplying the first modifying gas in step A1 are exemplified as follows:
Processing temperature: 300 to 850 degrees C, specifically 600 to 750 degrees C
Processing pressure: 1 to 5,000Pa
First modifying gas supply flow rate: 0.05 to 10.0slm
First modifying gas supply time: 5 to 300 seconds
Inert gas supply flow rate (for each gas supply pipe): 0 to 10slm

In the present disclosure, the processing temperature means the temperature of the wafe r 200 or the internal temperature of the process chamber 201, and the processing pressure mea ns the internal pressure of the process chamber 201. Further, the supply flow rate of oslm mean s a case where no gas is supplied. These apply equally to the following description.

As the first modifying gas, for example, a gas containing halogen may be used. The halog en includes at least one selected from the group of chlorine (Cl), fluorine (F), bromine (Br), and i odine (I). Examples of the first modifying gas may include a fluorine (F2) gas, a chlorine (Cl₂) g as, a bromine (Br₂) gas, an iodine (I₂) gas, a nitrogen fluoride (NF₃) gas, a chlorine fluoride (ClF₃ ) gas, a hydrogen fluoride (HF) gas, a hydrogen chloride (HCl) gas, a hydrogen bromide (HBr) g as, and a hydrogen iodide (HI) gas. One or more of these gases may be used as the first modifyi ng gas.

Further, as the first modifying gas, for example, a halosilane gas containing silicon (Si) a nd halogen may be used. As the halosilane gas, for example, a chlorosilane gas containing Si an d Cl, such as a dichlorosilane (SiH₂Cl₂) gas, a trichlorosilane (SiHCl₃) gas, a tetrachlorosilane (Si Cl₄), a pentachlorodisilane (Si₂H₁Cl₅), and a hexachlorodisilane (Si₂Cl₆) gas, may be used. One o r more of these gases may be used as the first modifying gas.

Further, as the first modifying gas, a gas containing an organic compound may be used. As the gas containing an organic compound, a gas containing at least one selected from the grou p consisting of an ether compound, a ketone compound, an amine compound, and an organic hy drazine compound may be used. As the gas containing an ether compound, a gas containing at l east one selected from the group of dimethylether, diethylether, methyl ethyl ether, propylether, i sopropylether, furan, tetrahydrofuran, pyran, tetrahydropyran, etc. may be used. As the gas con taining a ketone compound, a gas containing at least one selected from the group of dimethylket one, diethylketone, methylethylketone, methylpropylketone, etc. may be used. As the gas contai ning an amine compound, a gas containing at least one selected from the group of a methylamin e compound such as monomethylamine, dimethylamine, or trimethylamine, an ethylamine com pound such as monoethylamine, diethylamine, or triethylamine, and a methylethylamine compo und such as dimethylethylamine or methyldiethylamine may be used. As the gas containing an organic hydrazine compound, a gas containing at least one selected from the group of methylhyd razine-based gases such as monomethylhydrazine, dimethylhydrazine, and trimethylhydrazine may be used. One or more of these gases may be used as the first modifying gas.

As the inert gas, a nitrogen (N₂) gas or a rare gas such as an argon (Ar) gas, a helium (He ) gas, a neon (Ne) gas, a xenon (Xe) gas, or the like may be used. This point also applies to each step to be described later. One or more of these gases may be used as the inert gas.

After the first modifying gas is adsorbed on the surface of the wafer 200 (the surface insi de the recess 300), the valve 243a is closed to stop the supply of the first modifying gas into the process chamber 201. Then, the interior of the process chamber 201 is vacuum-exhausted to re move a gaseous substance and the like remaining in the process chamber 201 from the interior o f the process chamber 201. At this time, the valves 243g to 243i are opened to allow an inert gas to be supplied into the process chamber 201 via the nozzles 249a to 249c. The inert gas supplied from the nozzles 249a to 249c acts as a purge gas, whereby a space where the wafer 200 is place d, that is, the interior of the process chamber 201, is purged (purging).

### [Step A2]

After step A1 is completed, a first precursor gas containing a first element is supplied to t he wafer 200 in the process chamber 201, that is, the wafer 200 after the first modifying gas has been adsorbed on the surface of the recess 300.

Specifically, the valve 243d is opened to allow the first precursor gas to flow into the gas supply pipe 232d. The flow rate of the first precursor gas is adjusted by the MFC 241d, and the f irst precursor gas is supplied into the process chamber 201 via the gas supply pipe 232a and the nozzle 249a and is exhausted through the exhaust port 231a. In this operation, the first precurs or gas is supplied to the wafer 200 (first precursor gas supply). At this time, the valves 243g to 2 43i may be opened to allow an inert gas to be supplied into the process chamber 201 via the nozz les 249a to 249c, respectively.

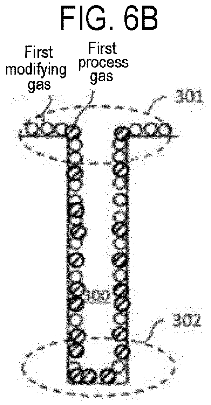

By supplying the first precursor gas containing the first element to the wafer 200 under t he process conditions to be described later, the first precursor gas can be adsorbed on locations of the surface of the wafer 200 (the surface inside the recess 300) where the first modifying gas i s not adsorbed (see FIG. 6B). More specifically, the adsorption of the first precursor gas is inhib ited at locations of the surface inside the recess 300 where the first modifying gas is adsorbed, a nd the first precursor gas (the first element) is preferentially absorbed on locations of the surfac e inside the recess 300 where the first modifying gas is not adsorbed, thereby forming a first ele ment-containing layer at the locations (region).

The process conditions for supplying the first precursor gas in step A2 are exemplified as follows:
Processing pressure: 1 to 10,000Pa
First precursor gas supply flow rate: 0.05 to 3slm, specifically 0.1 to 2slm
First precursor gas supply time: 1 to 120 seconds, specifically 1 to 60 seconds
Other process conditions can be the same as those used for supplying the first modifyin g gas in step A1.

After forming the first element-containing layer on the surface of the wafer 200 (the surf ace inside the recess 300), the valve 243d is closed to stop the supply of the first precursor gas in to the process chamber 201. Then, a gaseous substance and the like remaining in the process ch amber 201 are removed from the interior of the process chamber 201 (purging) according to the same processing procedure and process conditions as those for purging in step A1.

### [Step A3]

After step A2 is completed, a first reaction gas is supplied to the wafer 200 in the process chamber 201, that is, the wafer 200 after the first element-containing layer has been formed on t he surface inside the recess 300.

Specifically, the valve 243c is opened to allow the first reaction gas to flow into the gas su pply pipe 232c. The flow rate of the first reaction gas is adjusted by the MFC 241c, and the first r eaction gas is supplied into the process chamber 201 via the nozzle 249c and is exhausted throug h the exhaust port 231a. In this operation, the first reaction gas is supplied to the wafer 200 (fir st reaction gas supply). At this time, the valves 243g to 243i may be opened to allow an inert gas to be supplied into the process chamber 201 via the nozzles 249a to 249c, respectively.

By supplying the first reaction gas to the wafer 200 after forming the first element-contai ning layer under the process conditions shown below, at least a portion of the first element-cont aining layer is caused to react with the first reaction gas, which makes it possible to form a first modified layer by modifying the first element-containing layer.

The process conditions for supplying the first reaction gas in step A3 are exemplified as f ollows:
Processing pressure: 1 to 10,000Pa
First reaction gas supply flow rate: 1 to 30slm, specifically 2 to 20slm
First reaction gas supply time: 1 to 120 seconds, specifically 1 to 60 seconds
Other process conditions can be the same as those used for supplying the first modifyin g gas in step A1.

As the first reaction gas, for example, an oxygen (O)-containing gas such as an oxygen (O ₂) gas, an ozone (O₃) gas, a hydrogen (H₂) gas+oxygen (O₂) gas, an oxygen radical (O₂*), or the li ke may be used. In the present disclosure, the description of two gases such as "H₂ gas+O₂ gas" t ogether means a mixed gas of H₂ gas and O₂ gas. When supplying the mixed gas, the two gases may be mixed (pre-mixed) in a supply pipe and then supplied into the process chamber 201, or t he two gases may be supplied separately from different supply pipes into the process chamber 2 01 and then mixed (post-mixed) in the process chamber 201. One or more of these gases may be used as the first reaction gas.

After the first element-containing layer formed inside the recess 300 is changed into the first modified layer, the valve 243c is closed to stop the supply of the first reaction gas into the pr ocess chamber 201. Then, a gaseous substance and the like remaining in the process chamber 2 01 are removed from the interior of the process chamber 201 (purging) according to the same pr ocessing procedure and process conditions as those for purging in step A1.

### [Performing Predetermined Number of Times]

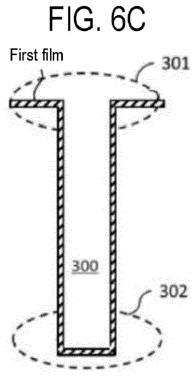

By performing a cycle n₁ times (n₁ is an integer of 1 or 2 or more), the cycle including non -simultaneously, that is, non-synchronously, performing steps A1, A2, and A3 in this order, it is possible to form a first film on the surface of the wafer 200 (see FIG. 6C). As the first precursor gas, for example, an Al-containing gas containing aluminum (Al) as the first element may be use d, and as the first reaction gas, for example, an oxygen (O)-containing gas may be used. In this c ase, an aluminum oxide film (AlO film) is formed as the first film on the surface of the wafer 200. The above cycle may be repeated a plurality of times. That is, the thickness of the first modifie d layer formed per cycle may be set to be smaller than a desired film thickness, and the above cy cle may be repeated a plurality of times until the thickness of the first film formed by stacking fir st modified layers reaches the desired film thickness.

### (Second Film Formation)

In the second film formation, the following steps B1, B2, and B3 are performed.

### [Step B1]

In step B1, a second modifying gas is supplied to the wafer 200 on which the first film ha s been formed.

Specifically, the valve 243b is opened to allow the second modifying gas to flow into the g as supply pipe 232b. The flow rate of the second modifying gas is adjusted by the MFC 241b, an d the second modifying gas is supplied into the process chamber 201 via the nozzle 249b and is e xhausted through the exhaust port 231a. In this operation, the second modifying gas is supplied to the wafer 200 (second modifying gas supply). At this time, the valves 243g to 243i may be op ened to allow an inert gas to be supplied into the process chamber 201 via the nozzles 249a to 24 9c, respectively.

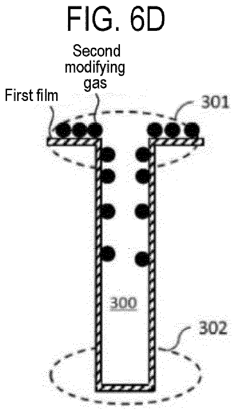

By supplying the second modifying gas to the wafer 200 under the process conditions to be described later, the second modifying gas is adsorbed on the surface of the first film, thereby modifying at least a portion of the surface of the first film. Further, by supplying the second mo difying gas to the wafer 200 under the process conditions to be described later, the second modi fying gas can be more readily adsorbed on the surface of the wafer 200 than the first modifying g as under the same conditions. By supplying the second modifying gas to the wafer 200 under th e process conditions to be described later, the amount of the second modifying gas adsorbed on t he deep side 302 of the recess 300 can be made smaller than the amount of the second modifyin g gas adsorbed on the opening side 301 of the recess 300 (see FIG. 6D). The second modifying g as prevents the adsorption of a second precursor gas and a second reaction gas on the first film t o inhibit (suppress) the progress of film formation reaction on the surface of the first film in step s B2 and B3 which will be described later.

The process conditions for supplying the second modifying gas in step B1 are exemplified as follows:
Processing pressure: 1 to 1,000Pa
Second modifying gas supply flow rate: 0.01 to 1slm
Second modifying gas supply time: 2 to 250 seconds

At this time, for the reason to be described later, it is preferable to set the conditions of st ep A1 and step B1 so that the second modifying gas is more readily adsorbed on the surface of th e wafer 200 than the first modifying gas under the same conditions. For example, it is preferabl e to set the pressure (processing pressure) in the space where the wafer 200 is placed in step B1 t o be lower than the processing pressure in step A1. Further, for example, it is preferable to set t he time for supplying the second modifying gas to the wafer 200 in step B1 to be shorter than th e time for supplying the first modifying gas to the wafer 200 in step A1. Further, for example, it is preferable to set the partial pressure of the second modifying gas in the space where the wafer 200 is placed (inside the process chamber 201) in step B1 to be lower than the partial pressure o f the first modifying gas in the process chamber 201 in step A1.

As the second modifying gas, a predetermined gas arbitrarily selected from the first modi fying gases exemplified in step A1 may be used. Note that the second modifying gas used in step B1 and the first modifying gas used in step A1 may be the same gas (gas with the same molecular structure) or different gases (gas with different molecular structures). When the first modifying gas and the second modifying gas are the same gas, the configuration of the gas supply system ca n be simplified.

When using a gas different from the first modifying gas as the second modifying gas, the gas types of the first modifying gas and the second modifying gas may be selected so that the ads orption capacity of the second modifying gas on the surface of the wafer 200 is higher than the a dsorption capacity of the first modifying gas. This allows the second modifying gas to be more r eadily adsorbed on the surface of the wafer 200 than the first modifying gas under the same con ditions, which is preferable for the reasons to be described later. For example, it is preferable to use the second modifying gas having a larger molecular weight than the first modifying gas. Fur ther, for example, it is preferable to use the second modifying gas having a larger molecular radi us than the first modifying gas. Further, for example, it is preferable to use the second modifyin g gas having higher reactivity to the surface of the wafer 200 than the first modifying gas under t he same conditions. Further, for example, it is preferable that the second precursor gas be a gas that chemically reacts with adsorption sites on the surface of the wafer 200 and that the first pre cursor gas be a gas that physically adsorbs with the adsorption sites on the surface of the wafer 2 00. As a result, the amount of the second modifying gas adsorbed on the deep side 302 of the re cess 300 can be easily made smaller than the amount of the first modifying gas adsorbed on the deep side 302 of the recess 300 in step A1. Here, the "adsorption capacity of a gas on the surface of the wafer 200" refers to the ease with which the gas can be adsorbed on the opening side 301 of the wafer 200. For example, when using an organic gas and an inorganic gas as the first prec ursor gas and the second precursor gas, an organic gas and an inorganic gas may be used as the f irst modifying gas and the second modifying gas in line with these.

After adsorbing the second modifying gas, the valve 243b is closed to stop the supply of t he second modifying gas into the process chamber 201. Then, a gaseous substance and the like r emaining in the process chamber 201 are removed from the interior of the process chamber 201 (purging) according to the same processing procedure and process conditions as those for purgi ng in step A1.

### [Step B2]

After step B1 is completed, a second precursor gas containing a second element is supplie d to the wafer 200 in the process chamber 201, that is, the wafer 200 after the second modifying gas has been adsorbed on the surface of the recess 300.

Specifically, the valve 243e is opened to allow the second precursor gas to flow into the g as supply pipe 232e. The flow rate of the second precursor gas is adjusted by the MFC 241e, and the second precursor gas is supplied into the process chamber 201 via the gas supply pipe 232b and the nozzle 249b and is exhausted through the exhaust port 231a. In this operation, the seco nd precursor gas is supplied to the wafer 200 (second precursor gas supply). At this time, the va lves 243g to 243i may be opened to allow an inert gas to be supplied into the process chamber 2 01 via the nozzles 249a to 249c, respectively.

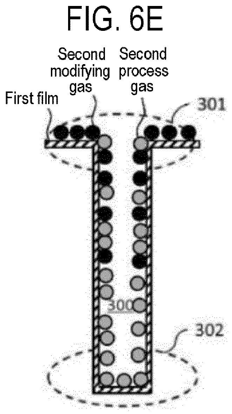

By supplying the second precursor gas containing the second element to the wafer 200 u nder the process conditions to be described later, the second precursor gas can be adsorbed on 1 ocations of the surface of the wafer 200 (the surface of the first film inside the recess 300) where the second modifying gas is not adsorbed (see FIG. 6E). More specifically, the adsorption of the second precursor gas is inhibited at locations of the surface of the first film inside the recess 300 where the second modifying gas is adsorbed, and the second precursor gas (the second element) is preferentially absorbed on locations of the surface of the first film inside the recess 300 where the second modifying gas is not adsorbed, thereby forming a second element-containing layer at the locations (region).

The process conditions for supplying the second precursor gas in step B2 are exemplified as follows:
Processing pressure: 1 to 10,000Pa
Second precursor gas supply flow rate: 0.05 to 3slm, specifically 0.1 to 2slm
Second precursor gas supply time: 1 to 120 seconds, specifically 1 to 60 seconds
Other process conditions can be the same as those used for supplying the first modifyin g gas in step A1.

Note that the first element contained in the first precursor gas and the second element co ntained in the second precursor gas may be the same element or may be different elements.

After forming the second element-containing layer on the first film, the valve 243e is clos ed to stop the supply of the second precursor gas into the process chamber 201. Then, a gaseous substance and the like remaining in the process chamber 201 are removed from the interior of t he process chamber 201 (purging) according to the same processing procedure and process cond itions as those for purging in step A1.

### [Step B3]

After step B2 is completed, a second reaction gas is supplied to the wafer 200 in the proc ess chamber 201, that is, the wafer 200 after the second element-containing layer has been form ed on the surface inside the recess 300.

Specifically, the valve 243f is opened to allow the second reaction gas to flow into the gas supply pipe 232f. The flow rate of the second reaction gas is adjusted by the MFC 241f, and the s econd reaction gas is supplied into the process chamber 201 via the gas supply pipe 232c and the nozzle 249c and is exhausted through the exhaust port 231a. In this operation, the second reacti on gas is supplied to the wafer 200 (second reaction gas supply). At this time, the valves 243g to 243i may be opened to allow an inert gas to be supplied into the process chamber 201 via the no zzles 249a to 249c, respectively.

By supplying the second reaction gas to the wafer 200 after forming the second element-containing layer under the process conditions shown below, at least a portion of the second elem ent-containing layer is caused to react with the second reaction gas, which makes it possible to f orm a second modified layer by modifying the second element-containing layer.

The process conditions for supplying the second reaction gas in step B3 are exemplified a s follows:
Processing pressure: 1 to 10,000Pa
Second reaction gas supply flow rate: 1 to 30slm, specifically 2 to 20slm
Second reaction gas supply time: 1 to 120 seconds, specifically 1 to 60 seconds
Other process conditions can be the same as those used for supplying the first modifyin g gas in step A1.

As the second reaction gas, a predetermined gas arbitrarily selected from the first reactio n gases exemplified in step A2 may be used. Note that the second reaction gas used in step B3 a nd the first reaction gas used in step A3 may have the same molecule structure or different mole cular structures.

### [Performing Predetermined Number of Times]

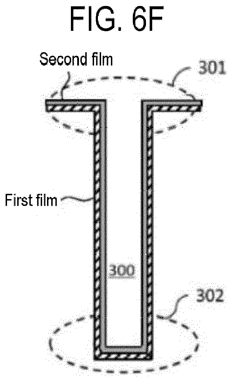

By performing a cycle n₂ times (n₂ is an integer of 1 or 2 or more), the cycle including non -simultaneously, that is, non-synchronously, performing steps B1, B2, and B3 in this order, it is possible to form a second film on the surface of the wafer 200 (see FIG. 6F). As the second prec ursor gas, for example, a Hf-containing gas containing hafnium (Hf) as the second element may be used, and as the second reaction gas, for example, an O-containing gas may be used. In this c ase, a hafnium oxide film (HfO film) is formed as the second film on the surface of the wafer 200. The above cycle may be repeated a plurality of times. That is, the thickness of the second modi fied layer formed per cycle may be set to be smaller than a desired film thickness, and the above cycle may be repeated a plurality of times until the thickness of the second film formed by stacki ng second modified layers reaches the desired film thickness.

By performing the cycle n₁ times (the first number of times), the cycle including performi ng steps A1, A2, and A3 in this order to form the first film and performing the cycle n₂ times (the second number of times), the cycle including performing steps B1, B2, and B3 in this order to for m the second film, a laminated film, which is formed by laminating the first film and the second film in this order, can be formed on the surface of the wafer 200.

### (After-Purging and Returning to Atmospheric Pressure)

After the formation of the laminated film is completed, an inert gas acting as a purge gas is supplied into the process chamber 201 from each of the nozzles 249a to 249c and is exhausted through the exhaust port 231a. Thus, the interior of the process chamber 201 is purged and a ga s, reaction by-products, and the like remaining in the process chamber 201 are removed from th e interior of the process chamber 201 (after-purging). After that, the internal atmosphere of the process chamber 201 is substituted with an inert gas (inert gas substitution) and the internal pre ssure of the process chamber 201 is returned to the atmospheric pressure (returning to atmosph eric pressure).

### (Boat Unloading and Wafer Discharging)

After that, the seal cap 219 is moved down by the boat elevator 115 to open the lower end of the manifold 209. Then, the processed wafers 200 supported by the boat 217 are unloaded fr om the lower end of the manifold 209 to the outside of the reaction tube 203 (boat unloading). After the boat unloading, the shutter 219s is moved and the lower end opening of the manifold 2 09 is sealed by the shutter 219s via the O-ring 220c (shutter close). The processed wafers 200 ar e unloaded from the reaction tube 203 and are then discharged from the boat 217 (wafer dischar ging).

### (3) Effects of the Present Embodiment

According to the present embodiment, in addition to the above-described effects, one or more effects set forth below may be achieved.
(a) In step B1, the conditions are such that the second modifying gas is more readily adso rbed on the surface of the wafer 200 than the first modifying gas under the same conditions. At this time, the amount of the second modifying gas adsorbed on the deep side 302 of the recess 3 00 is made smaller than the amount of the first modifying gas adsorbed on the deep side 302 of the recess 300 in step A1. As a result, the step coverage of the laminated film formed by laminat ing the first film and the second film can be improved. Further, in step B2, by making it easier t o adsorb the second precursor gas on the deep side 302 of the recess 300, the deposition rate ca n be improved. These will be explained below.

As described above, in step B2, the second precursor gas, which is more readily adsorbed on the opening side 301 than the first precursor gas under the same conditions, is supplied to th e wafer 200. Further, the gas supplied to the wafer 200 including the recess 300 tends to easily reach (adsorb on) the opening side 301 and hardly reach (adsorb on) the deep side 302. For this reason, the amount of the second precursor gas adsorbed on the opening side 301 tends to be lar ger and the amount of the second precursor gas adsorbed on the deep side 302 tends to be small er than the amount of the first precursor gas supplied under the same conditions. Therefore, for example, if the first modifying gas and the second modifying gas are adsorbed to the same exten t on the deep side 302, since the thickness of the second film on the deep side 302 tends to be s maller than the thickness of the first film, the step coverage of the second film is more likely to d ecrease than the step coverage of the first film. Therefore, the amount of the second modifying g as adsorbed on the deep side 302 is preferably smaller than the amount of the first modifying ga s adsorbed on the deep side 302. Further, when the step coverage of the second film decreases, t he step coverage of the laminated film formed by the first film and the second film also decrease s.

In this embodiment, in step B1, the conditions are such that the second modifying gas is more readily adsorbed on the surface of the wafer 200 than the first modifying gas under the sa me conditions. As a result, the amount of the second modifying gas adsorbed on the deep side 3 02 in step B1 can be made smaller than the amount of the first modifying gas adsorbed on the de ep side 302 in step A1. That is, the second modifying gas is preferentially adsorbed on the openi ng side 301 (see FIGS. 6A and 6D). As a result, the adsorption of the second precursor gas on th e opening side 301 can be likely to be inhibited, and the adsorption of the second precursor gas o n the deep side 302 can be less likely to be inhibited. This makes it possible to reduce a differen ce in the adsorption amount of the second precursor gas between the opening side 301 and the d eep side 302 of the recess 300, thereby making it possible to form the second film with excellent step coverage (see FIG. 6F). Since the step coverage of the second film is improved, the step cov erage of the laminated film can be improved.

Further, since the process gas (the precursor gas or the reaction gas) is more difficult to r each the deep side 302 of the recess 300 than the opening side 301 of the recess 300, the amoun t of the process gas adsorbed on the deep side 302 is smaller than the amount of the process gas adsorbed on the opening side 301. Therefore, if the second modifying gas is adsorbed on the dee p side 302, this will lead to an overall delay in the formation of the second film. In this embodi ment, as described above, the second modifying gas is preferentially adsorbed on the opening si de 301. In other words, the amount of the second modifying gas adsorbed on the deep side 302 i s reduced. Therefore, even when a gas that inhibits the adsorption of the process gas is used, it i s possible to suppress a decrease in the deposition rate of the second film on the deep side 302. This leads to suppressing a decrease in the deposition rates of the second film and the laminated film. However, it is preferable to set the supply conditions of the second modifying gas in step B 1 so that the step coverage of the second film is not adversely affected by excessive adsorption of the second modifying gas on the opening side 301.

(b) By setting the amount of the first modifying gas adsorbed on the deep side 302 of the recess 300 to be smaller than the amount of the first modifying gas adsorbed on the opening sid e 301 of the recess 300 (see FIG. 6A), the adsorption of the first precursor gas on the opening sid e 301 is likely to be inhibited, and the adsorption of the first precursor gas on the deep side 302 i s less likely to be inhibited. This makes it possible to reduce a difference in the adsorption amou nt of the first precursor gas between the opening side 301 and the deep side 302 of the recess 30 0, thereby making it possible to form the first film and the laminated film with excellent step cov erage (see FIG. 6C).

(c) The pressure (processing pressure) in the space where the wafer 200 is placed in step B1 may be lower than the processing pressure in step A1. As a result, the amount of the second modifying gas adsorbed on the deep side 302 of the recess 300 in step B1 can be made smaller t han the amount of the first modifying gas adsorbed on the deep side 302 of the recess 300 in ste p A1. Therefore, the step coverage and deposition rate of the second film and the laminated film can be improved.

(d) The time for supplying the second modifying gas to the wafer 200 in step B1 may be s horter than the time for supplying the first modifying gas to the wafer 200 in step A1. As a resul t, the amount of the second modifying gas adsorbed on the deep side 302 of the recess 300 in ste p B1 can be made smaller than the amount of the first modifying gas adsorbed on the deep side 3 02 of the recess 300 in step A1. Therefore, the step coverage and deposition rate of the second fi lm and the laminated film can be improved.

(e) The partial pressure of the second modifying gas in the space where the wafer 200 is placed (inside the process chamber 201) in step B1 may be made smaller than the partial pressur e of the first modifying gas in the process chamber 201 in step A1. As a result, the amount of the second modifying gas adsorbed on the deep side 302 of the recess 300 in step B1 can be made s maller than the amount of the first modifying gas adsorbed on the deep side 302 of the recess 30 0 in step A1. Therefore, the step coverage and deposition rate of the second film and the laminat ed film can be improved.

(f) By using the second modifying gas that has higher adsorption capacity on the opening side 301 of the wafer 200 than the first modifying gas, the step coverage and deposition rate of t he second film and the laminated film can be further improved.

(g) By using at least one of the first precursor gas or the second precursor gas as a gas tha t does not include organic ligands, the amount of carbon (C) introduced into the laminated film as impurities can be reduced. As a result, the etching resistance and electrical characteristics of the first film and/or the second film and the laminated film can be improved.

(h) The above-described effects can be similarly obtained even when a predetermined ga s arbitrarily selected from various modifying gases, various precursor gases, various reaction gas es, and various inert gases is used.

### <Other Embodiments of the Present Disclosure>

The various embodiments of the present disclosure have been specifically described abov e. However, the present disclosure is not limited to the above-described embodiments, and vari ous changes can be made without departing from the gist thereof.

For example, in the above-described embodiments, a case has been described in which af ter the first film is formed, the second film is formed to form the laminated film. That is, the cas e has been described in which after performing the cycle n₁ times, the cycle including performin g steps A1, A2, and A3 in this order, the cycle including performing steps B1, B2, and B3 in this o rder is performed n₂ times to form a film containing the first element and the second element. However, the present disclosure is not limited to these embodiments. For example, after the sec ond film is formed, the first film may be formed to form the laminated film. That is, after perfor ming the cycle n₂ times, the cycle including performing steps B1, B2, and B3 in this order, the cy cle including performing steps A1, A2, and A3 in this order may be performed n₁ times to form a film containing the first element and the second element. Also in these cases, the same effects a s in the above-described embodiments can be obtained.

For example, in the above-described embodiments, a case has been described in which t he laminated film constituted by the first film containing the first element and the second film c ontaining the second element is formed. However, the present disclosure is not limited to this e mbodiment. For example, one gas, which is less likely to be adsorbed on the surface of the wafer 200, of a first gas containing the first element and a second gas containing the second element may be set as a first process gas, the other gas of the first gas containing the first element and th e second gas containing the second element may be set as a second process gas, and a film contai ning the first element and the second element (a film mainly containing the first element and th e second element) may be formed. For example, of a tetrachlorotitanium (TiCl₄) gas containing titanium (Ti), which is a metal element, and an ammonia (NH₃) gas containing nitrogen (N), the NH₃ gas, which is less likely to be adsorbed on the surface of the wafer 200, may be used as the f irst process gas (reaction gas), and the TiCl₄ gas may be used as the second process gas (precurs or gas). In this case, the first element is N, the second element is Ti, and a titanium nitride film ( TiN film) is formed as a film containing the first element and the second element. That is, one o f the first process gas and the second process gas may be a precursor gas, and the other gas may be a reaction gas. In this case, as the precursor gas, gases exemplified as the first precursor gas a nd the second precursor gas may be used as will be described later. Further, as the reaction gas, gases exemplified as the first reaction gas and the second reaction gas may be used as will be des cribed later. Also in this case, the same effects as in the above-described embodiments can be o btained.

For example, in the above-described embodiments, a case has been described in which t he first film formation and the second film formation are performed once respectively to form th e laminated film. However, the present disclosure is not limited to this embodiment. For exam ple, the first film formation and the second film formation may be alternately performed a plural ity of times to form the laminated film. Even in this case, the same effects as in the above-descri bed embodiments can be obtained. Here, the laminated film formed by laminating the first film containing the first element and the second film containing the second element may be a film co ntaining the first element and the second element.

For example, in the above-described embodiments, a case has been described as an exam ple in which both the first reaction gas and the second reaction gas are the O-containing gas. Ho wever, the present disclosure is not limited to this embodiment. For example, in addition to the O-containing gas, the first reaction gas and the second reaction gas may be a nitrogen (N)-contai ning gas, a carbon (C)-containing gas such as an organic gas, a hydrogen (H)-containing gas suc h as a H₂ gas, and a mixture of these gases. Examples of the N-containing gas may include nitro gen-containing gases containing N-H bonds (N- and H-containing gases) such as an ammonia ( NH₃) gas, a hydrazine (N₂H₄) gas, a diazene (N₂H₂) gas, and a N₃H₈ gas, and a N₂ gas. By supply ing these gases to the wafer 200, for example, a metal film, a metal nitride film, a metal carbide f ilm, a metal oxynitride film, a metal oxycarbide film, a metal carbonitride film, or a metal oxycar bonitride film may be formed as the first film and/or the second film, or the laminated film. Eve n in these cases, the same effects as in the above-described embodiments can be obtained.

When the first element and the second element are, for example, Si, a gas containing, for example, halogen and Si, that is, a halosilane-based gas, may be used as the first precursor gas a nd the second precursor gas. The halogens include chlorine (Cl), fluorine (F), bromine (Br), iodi ne (I), and the like. As the halosilane-based gas, for example, the above-mentioned chlorosilane -based gas containing Cl and Si may be used.

Examples of the first precursor gas and/or the second precursor gas may include gases c ontaining metal elements such as titanium (Ti), zirconium (Zr), hafnium (Hf), tantalum (Ta), ni obium (Nb), aluminum (Al), molybdenum (Mo), tungsten (W), silicon (Si), and germanium (Ge) , as the first element and/or the second element. As the gas containing the metal element, a gas containing a molecule having a metal element and a ligand bonded thereto, such as trimethylalu minum (Al(CH₃)₃) gas, may be used. An example of the ligand may include an organic ligand, pr eferably a hydrocarbon group containing at least one selected from the group consisting of an al kyl group such as a methyl group, an ethyl group, a propyl group, or a butyl group, a cyclopentad ienyl group, a cyclohexadienyl group, and a cycloheptatrienyl group.

Here, as the first precursor gas and/or the second precursor gas containing Zr, for examp le, a gas containing at least one selected from the group consisting of tetrakisethylmethylaminoz irconium (Zr[N(CH₃)C₂H₅]₄), tetrakisdiethylaminozirconium (Zr[N(C₂H₅)₂]₄), tetrakisdimethyla minozirconium (Zr[N(CH₃)₂]₄), Zr(MMP)₄, Zr(O-tBu)₄, and trisdimethylaminocyclopentadienyl zirconium ((C₅H₅)Zr[N(CH₃)₂]₃) may be used. One or more of these may be used as the first pre cursor gas and/or the second precursor gas.

Further, as the gas containing Hf as the first element and/or the second element, for exa mple, a gas containing at least one selected from the group consisting of tetrakisethylmethylami nohafnium (Hf[N(CH₃)C₂H₅]₄), tetrakisdiethylaminohafnium (Hf[N(C₂H₅)₂]₄), tetrakisdimethyl aminohafnium (Hf[N(CH₃)₂]₄), Hf(O-tBu)₄, Hf(MMP)₄, and trisdimethylaminocyclopentadienyl hafnium ((C₅H₅)Hf[N(CH₃)₂]₃) may be used. One or more of these may be used as the first prec ursor gas and/or the second precursor gas.

Further, as the gas containing Ti as the first element and/or second element, for example , a gas containing at least one selected from the group consisting of tetrakisethylmethylaminotit anium (Ti[N(CH₃)C₂H₅]₄), tetrakisdiethylaminotitanium (Ti[N(C₂H₅)₂]₄), tetrakisdimethylamino titanium (Ti[N(CH₃)₂]₄), Ti(O-tBu)₄, Ti(MMP)₄, and trisdimethylaminocyclopentadienyltitaniu m ((C₅H₅)Ti[N(CH₃)₂]₃) may be used. One or more of these may be used as the first precursor ga s and/or the second precursor gas.

Further, as the first precursor gas and/or the second precursor gas, for example, inorgan ic metal precursor gases containing a metal element and a halogen element, such as a titanium t etrachloride (TiCl₄) gas, a titanium tetrafluoride (TiF₄) gas, a zirconium tetrachloride (ZrCl₄) gas , a zirconium tetrafluoride (ZrF₄) gas, a hafnium tetrachloride (HfCl₄) gas, a hafnium tetrafluori de (HfF₄) gas, a tantalum pentachloride (TaCl₅) gas, a tantalum pentafluoride (TaF₅) gas, a niobi um pentachloride (NbCl₅) gas, a niobium pentafluoride (NbF₅) gas, an aluminum trichloride (Al Cl₃) gas, an aluminum trifluoride (AlF₃) gas, a molybdenum pentachloride (MoCl₅) gas, a molyb denum pentafluoride (MoF₅) gas, a tungsten hexachloride (WCl₆) gas, and tungsten hexafluoride (WF₆) gas, may also be used. One or more of these may be used as the first precursor gas and/or the second precursor gas.

Further, as the gas containing Si as the first element and/or the second element, for exa mple, silane-based gases such as a monosilane (SiH₄) gas, a disilane (Si₂H₆) gas, and a trisilane ( Si₃H₈) gas may be used. Further, the above-mentioned halosilane gas may also be used. One or more of these gases may be used as the first precursor gas and/or the second precursor gas.

As described above, the second precursor gas (second process gas) is a gas that is more r eadily adsorbed on the surface of the wafer 200 than the first precursor gas (first process gas) un der the same conditions. Such a relationship is likely to be established, for example, when a gas having higher reactivity to the surface of the wafer 200 than the first precursor gas under the sa me conditions is used as the second precursor gas. Further, this relationship is also likely to be e stablished, for example, when a gas containing a functional group having higher reactivity to ads orption sites present on the surface of the wafer 200 than the first precursor gas under the same conditions is used as the second precursor gas. Further, this relationship is likely to be establish ed, for example, when a gas that does not have a cyclic structure in molecules is used as the first precursor gas and a gas that has a cyclic structure (for example, a five-membered carbocyclic str ucture) in molecules is used as the second precursor gas. Further, this relationship is likely to be established when a gas containing more ligands than the first precursor gas is used as the secon d precursor gas. Further, a gas having a larger molecular weight may be more likely to be adsor bed on the surface of the wafer 200 due to a Van der Waals force with the surface of the wafer 2 00. From this, even when a gas having a molecular weight larger than that of the first precursor gas is used as the second precursor gas, the second precursor gas may be more likely to be adsor bed on the surface of the wafer 200 than the first precursor gas under the same conditions.

For example, in the above-described embodiments, a case has been described in which t he first process gas includes the first precursor gas containing the first element and the first reac tion gas and the second process gas includes the second precursor gas containing the second ele ment and the second reaction gas. However, the present disclosure is not limited to this embodi ment. For example, the first process gas may not include the first reaction gas, and the second p rocess gas may not include the second reaction gas. In other words, in the first film formation, it is not necessary to perform the first reaction gas supplying step (step A3), and in the second film formation, it is not necessary to perform the second reaction gas supplying step (step B3). Even in these cases, the same effects as in the above-described embodiments can be obtained.

For example, in the above-described embodiments, a case has been described in which t he first modifying gas is supplied once in step A1. However, the present disclosure is not limited to this embodiment. For example, in step A1, the interior of the process chamber 201 may be pu rged or vacuum-exhausted, and the first modifying gas may be supplied in multiple steps. Even in this case, the same effects as in the above-embodiments can be obtained. The same applies to the supply of the first precursor gas, the supply of the first reaction gas, the supply of the second modifying gas, the supply of the second precursor gas, and the supply of the second reaction gas in steps A2, A3, B1, B2, and B3, respectively.

For example, in the above-described embodiments, a case has been described in which st eps A1, A2, and A3 are performed in this order a predetermined number of times in the first film formation. However, the present disclosure is not limited to this embodiment. For example, aft er steps A1, A2, and A3 are performed a predetermined number of times, only steps A2 and A3 may be performed a predetermined number of times. Even in this case, the same effects as in th e above-described embodiments can be obtained. The same applies to the second film formatio n (steps B1, B2, and B3).

For example, in step B1, while setting the partial pressure of the second modifying gas to be lower than the partial pressure of the first modifying gas in step A1, the supply time of the sec ond modifying gas may be set to be longer than the supply time of the first modifying gas in step A1. By doing so, it is possible to increase the amount of the second modifying gas adsorbed on t he opening side 301 while suppressing an increase in the amount of the second modifying gas ad sorbed on the deep side 302. Therefore, the effects of the above-described embodiments can be further enhanced.

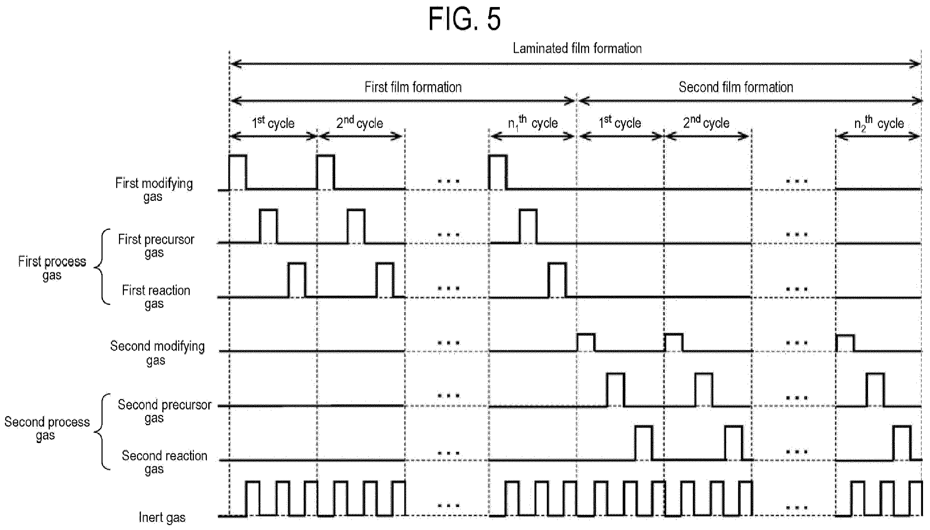

For example, it is preferable to set the supply flow rate of the second modifying gas in ste p B1 to be smaller than the supply flow rate of the first modifying gas in step A1 (see FIG. 5). By doing so, since the partial pressure of the second modifying gas in step B1 can be set to be lower than the partial pressure of the first modifying gas in step A1, the amount of the second modifyi ng gas adsorbed on the deep side 302 of the recess 300 in step B1 can be made smaller than the amount of the first modifying gas adsorbed on the deep side 302 of the recess 300 in step A1. As a result, the same effects as in the above-described embodiments can be obtained.

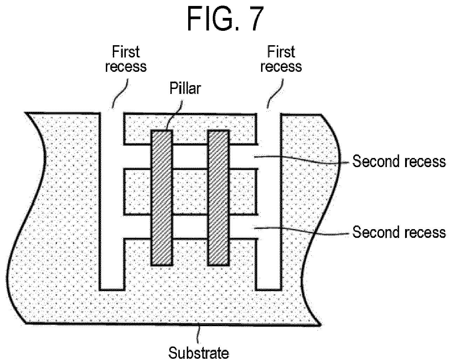

For example, in the above-described embodiments, as shown in FIG. 6A, a case has been described as an example in which the recess 300 formed in the wafer 200 has an opening facing a space in which the wafer 200 is processed. However, the present disclosure is not limited to th is embodiment. For example, as shown in FIG. 7, a recess formed in a substrate may include a fi rst recess having an opening facing the space in which the substrate is processed, and a second r ecess having an opening within the first recess. Further, a plurality of pillars may be formed insi de the substrate, for example, to cross the second recess in the same direction as the depth direc tion (for example, the vertical direction) of the first recess. A space through which a supplied ga s can communicate is formed between the pillars inside the second recess. When the substrate h aving such a structure is processed according to the above-described embodiments, a film is for med on the surfaces of the first recess, the surfaces of the second recess, and the surfaces of the pillars. Even when such a substrate is used, the same effects as in the above-described embodim ents can be obtained.

For example, in the above-described embodiments, a case has been described in which a film containing the first element and the second element is formed on the surface of the recess 3 00 formed in the wafer 200. However, the present disclosure is not limited to this embodiment. For example, the inside of the recess 300 may be filled with the film containing the first element and the second element by forming the film containing the first element and the second element a predetermined number of times (once or more) (filling film formation or bottom-up film form ation). In this case, the amount and size of voids (seams) present in the film can be reduced.

Further, for example, in the above-described embodiments, a case has been described in which a film containing the first element and the second element is formed on the surface of the recess 300 provided in the wafer 200. However, the present disclosure is not limited to this em bodiment. For example, if the wafer 200 includes a first surface and a second surface different f rom the first surface and the second process gas (the second precursor gas and/or the second re action gas) is a gas that is more readily adsorbed on the first surface than the first process gas (t he first precursor gas and/or the first reaction gas) under the same conditions, a step of supplyin g a gas corresponding to each of the first modifying gas, the first process gas, the second modifyi ng gas, and the second process gas may be performed to selectively form a film containing the fir st element and the second element on the second surface. In this case, step B1 is performed und er the conditions in which the second modifying gas is more readily adsorbed on the first surface than the first modifying gas under the same conditions. As a result, formation of a film on the fi rst surface, that is, selectivity loss, can be suppressed.

Recipes used in each process may be prepared individually according to the processing c ontents and may be recorded and stored in the memory 121c via a telecommunication line or the external memory 123. Moreover, at the beginning of each process, the CPU 121a may properly s elect an appropriate recipe from the recipes recorded and stored in the memory 121c according t o the processing contents. Thus, it is possible for a single substrate processing apparatus to for m films of various kinds, composition ratios, qualities, and thicknesses with enhanced reproduci bility. Further, it is possible to reduce an operator's burden and to quickly start each process wh ile avoiding an operation error.

The recipes mentioned above are not limited to newly-prepared ones but may be prepare d, for example, by modifying existing recipes that are already installed in the substrate processin g apparatus. Once the recipes are modified, the modified recipes may be installed in the substra te processing apparatus via a telecommunication line or a recording medium storing the recipes. In addition, the existing recipes already installed in the existing substrate processing apparatus may be directly modified by operating the input/output device 122 of the substrate processing a pparatus.

An example in which a film is formed using a batch-type substrate processing apparatus capable of processing a plurality of substrates at a time has been described in the above-describe d embodiments. The present disclosure is not limited to the above-described embodiments, but may be suitably applied, for example, to a case where a film is formed using a single-wafer type s ubstrate processing apparatus capable of processing a single substrate or several substrates at a time. In addition, an example in which a film is formed using a substrate processing apparatus provided with a hot-wall-type process furnace has been described in the above-described embod iments. The present disclosure is not limited to the above-described embodiments, but may be s uitably applied to a case where a film is formed using a substrate processing apparatus provided with a cold-wall-type process furnace. Even in the case of using these substrate processing appa ratuses, each process may be performed according to the same processing procedures and proce ss conditions as those in the above-described embodiments and modifications, and the same eff ects as in the above-described embodiments and modifications are achieved.

The above-described embodiments and modifications may be used in proper combinatio n. The processing procedures and process conditions used in this case may be the same as, for e xample, the processing procedures and process conditions in the above-described embodiments and modifications.

According to the present disclosure in some embodiments, it is possible to improve the st ep coverage of a film formed on a substrate.

While certain embodiments have been described, these embodiments have been present ed by way of example only, and are not intended to limit the scope of the disclosures. Indeed, th e embodiments described herein may be embodied in a variety of other forms. Furthermore, var ious omissions, substitutions and changes in the form of the embodiments described herein may be made without departing from the spirit of the disclosures. The accompanying claims and thei r equivalents are intended to cover such forms or modifications as would fall within the scope an d spirit of the disclosures.

## Claims

1. A method of processing a substrate, comprising:
(a1) supplying a first modifying gas to the substrate;
(a2) supplying a first process gas containing a first element to the substrate;
(b1) supplying a second modifying gas to the substrate; and
(b2) supplying a second process gas, which contains a second element and is more readily adsorbed on a surface of the substrate than the first process gas under a same condition, to the s ubstrate,
wherein (a1) and (a2) are performed a first number of times and (b1) and (b2) are perfor med a second number of times to form a film containing the first element and the second eleme nt, and
wherein (b1) is performed under a condition in which the second modifying gas is more re adily adsorbed on the surface of the substrate than the first modifying gas under a same conditio n.

2. The method of Claim 1, wherein the substrate includes a recess.

3. The method of Claim 1, wherein the first modifying gas is a gas that inhibits a reaction bet ween the first process gas and the surface of the substrate, and
wherein the second modifying gas is a gas that inhibits a reaction between the second pro cess gas and the surface of the substrate.

4. The method of Claim 1, wherein a molecular weight of the second process gas is larger tha n a molecular weight of the first process gas.

5. The method of Claim 1, wherein a reactivity of the second process gas to the surface of the substrate is higher than a reactivity of the first process gas to the surface of the substrate under a same condition.

6. The method of any one of Claims 1 to 5, wherein a pressure in a space where the substrate is placed in (b1) is set to be lower than a pressure in the space in (a1).

7. The method of any one of Claims 1 to 5, wherein a time for supplying the second modifyin g gas to the substrate in (b1) is set to be shorter than a time for supplying the first modifying gas to the substrate in (a1).

8. The method of any one of Claims 1 to 5, wherein a partial pressure of the second modifyin g gas in a space where the substrate is placed in (b1) is set to be lower than a partial pressure of t he first modifying gas in the space in (a1).

9. The method any one of Claims 1 to 5, wherein the first modifying gas and the second modi fying gas are a same gas.

10. The method of any one of Claims 1 to 5, wherein the first modifying gas and the second m odifying gas are different gases.

11. The method of any one of Claims 1 to 5, further comprising:
(a3) supplying a first precursor gas containing the first element and a first reaction gas a s the first process gas in (a2); and
(b3) supplying a second precursor gas containing the second element and a second react ion gas as the second process gas in (b2),
wherein at least one selected from the group of (a3) and (b3) is performed.

12. The method of any one of Claims 1 to 5, wherein one gas of the first process gas and the se cond process gas is a precursor gas and the other gas of the first process gas and the second proc ess gas is a reaction gas.

13. A method of manufacturing a semiconductor device comprising the method of Claim 1.

14. A substrate processing apparatus comprising:
a first modifying gas supplier configured to supply a first modifying gas to a substrate;
a first process gas supplier configured to supply a first process gas containing a first eleme nt to the substrate;
a second modifying gas supplier configured to supply a second modifying gas to the substr ate;
a second process gas supplier configured to supply a second process gas, which contains a second element and is more readily adsorbed on a surface of the substrate than the first process gas under a same condition, to the substrate; and
a controller configured to be capable of controlling the first modifying gas supplier, the fir st process gas supplier, the second modifying gas supplier, and the second process gas supplier t o perform a process including:
(a1) supplying the first modifying gas to the substrate;
(a2) supplying the first process gas to the substrate;
(b1) supplying the second modifying gas to the substrate; and
(b2) supplying the second process gas to the substrate,
wherein (a1) and (a2) are performed a first number of times and (b1) and (b2) a re performed a second number of times to form a film containing the first element and t he second element, and
wherein (b1) is performed under a condition in which the second modifying gas is more readily adsorbed on the surface of the substrate than the first modifying gas und er a same condition.

15. A program that causes, by a computer, a substrate processing apparatus to perform a proc ess comprising:
(a1) supplying a first modifying gas to a substrate;
(a2) supplying a first process gas containing a first element to the substrate;
(b1) supplying a second modifying gas to the substrate; and
(b2) supplying a second process gas, which contains a second element and is more readily adsorbed on a surface of the substrate than the first process gas under a same condition, to the s ubstrate,
wherein (a1) and (a2) are performed a first number of times and (b1) and (b2) are perfor med a second number of times to form a film containing the first element and the second eleme nt, and
wherein (b1) is performed under the conditions in which the second modifying gas is mor e readily adsorbed on the surface of the substrate than the first modifying gas under a same con dition.
